Europäisches Patentamt

European Patent Office

Office européen des brevets

(11) Publication number: **0 292 278**
**A1**

# EUROPEAN PATENT APPLICATION

(21) Application number: 88304531.2

(22) Date of filing: 19.05.88

(51) Int. Cl.⁴: **H 01 L 29/04**
**H 01 L 29/08**

(30) Priority: 19.05.87 JP 120298/87

(43) Date of publication of application:
23.11.88 Bulletin 88/47

(84) Designated Contracting States: DE FR GB

(71) Applicant: **FUJITSU LIMITED**
**1015, Kamikodanaka Nakahara-ku**
**Kawasaki-shi Kanagawa 211 (JP)**

(72) Inventor: **Fujioka, Hiroshi**
**1-15-19-901, Nishikata**
**Bunkyo-ku Tokyo 113 (JP)**

**Takasaka, Kanetake**
**1-26-10-703, Omorikita Ota-ku**
**Tokyo 143 (JP)**

(74) Representative: **Silverman, Warren et al**
**HASELTINE LAKE & CO. Hazlitt House 28 Southampton**
**Buildings Chancery Lane**
**London WC2A 1AT (GB)**

(54) Bipolar transistor and method for producing same.

(57) A heterojunction bipolar transistor comprises a silicon substrate collector, an impurity-doped base region in the substrate, an emitter of a microcrystalline material ($\mu$c) selected from

$\mu$c-Si:H (hydrogenated), $\mu$c-SiN:H, $\mu$c-SiGe:H, uc-Si:H:F (hydrogenated and fluorinated), $\mu$c-SiN:H:F, and $\mu$c-SiGe:H:F formed on the base region, and an emitter electrode formed on the emitter. The microcrystalline material is formed by a plasma CVD process.

*Fig. I*

## Description

## BIPOLAR TRANSISTOR AND METHOD FOR PRODUCING SAME

The present invention relates to a bipolar transistor, more particularly, to a heterojunction bipolar transistor (HBT).

In an HBT, a heterojunction is formed between an emitter and a base thereof, and a bandgap of the emitter is larger than that of the base. The fundamental features of the HBT are that a minority carrier does not flow from the base to the emitter, that an impurity concentration of the base region can be raised maintaining an emitter efficiency at a high level, and that a resistance of the internal (active) base region can be lowered. In consequence, a current gain (current amplification factor) and a cutoff frequency $f_T$ of the HBT are remarkably improved, compared with those of a conventional bipolar transistor. Such an HBT has been produced by using a compound semiconductor (e.g., AlGaAs/GaAs) (see, for example, Masamichi Ohmori, editor: "Ultra-High Speed Compound Semiconductor Devices", Baifukan, 1986, pp. 105 - 117).

Recently, attempts have been made to produce an HBT by using silicon (Si) instead of the compound semiconductor. In this case, a wide bandgap emitter of hydrogenated amorphous silicon (a-Si:H), hydrogenated amorphous silicon carbide (a-SiC:H), crystalline silicon carbide ($\beta$-SiC) or the like, is formed on a surface of a base region in a silicon substrate.

A high temperature (e.g., 1000°C) is required for the growth of $\beta$-SiC, and thus impurities of a base region and a collector region are undesirably diffused in the silicon substrate. In addition, defects caused by a lattice mismatch between the $\beta$-SiC and Si occur, with the result that the characteristics of the transistor are undesirably deteriorated. However, in the case of amorphous materials such as a-Si:H and a-SiC:H, although the growth of the amorphous material at a low temperature (200 to 400°C) can be carried out by a plasma CVD process, a drawback exists in that the amorphous material has a high resistance. Thus if the amorphous material is doped with impurities, the resistivity thereof is lowered to not more than about 100 $\Omega$cm and the resistance becomes a parasitic resistance, and an improvement of the characteristics of the transistor can not realized.

An object of the present invention is to provide an HBT formed of Si and employing another material for a wide bandgap emitter in place of the above-mentioned a-Si:H, a-SiC:H and $\beta$-SiC so that the HBT does not have drawbacks caused by these materials.

Another object of the present invention is to provide a high-speed and high current gain HBT using a silicon substrate, and a method for producing such an HBT.

These and other objects of the present invention are realized by providing a heterojunction bipolar transistor (HBT) comprising a silicon substrate as a collector, an impurity-doped base region in the substrate, an emitter formed of a microcrystalline material selected from $\mu$c-Si:H, $\mu$c-SiN:H, $\mu$c-SiGe:H, $\mu$c-Si:H:F, $\mu$c-SiN:H:F and $\mu$c-SiGe:H:F on the base region, and an emitter electrode formed on the emitter.

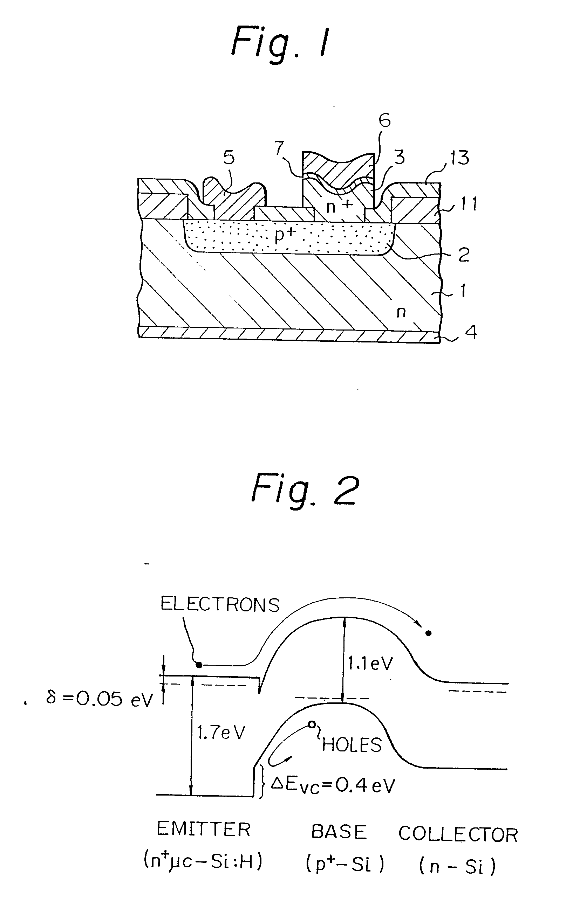

The microcrystalline material (referred to hereinafter as $\mu$c) is a crystal formed of a mixture of an amorphous substance and a crystalline substance, and is constituted by silicon or a compound thereof hydrogenated (referred to hereinafter as :H) or hydrogenated and fluorinated (referred to hereinafter as :H:F) by a plasma CVD process. For example, where an emitter is made of a phosphorus-doped n⁺ $\mu$c-Si:H and an npn-type HBT (Fig. 1) is produced by using the emitter, an energy band of the HBT as shown in Fig. 2 is obtained. In this case, a barrier is formed which will block the injection of holes from the base to emitter. The resistivity of the n⁺ $\mu$c/si:H can be set to 0.1 $\Omega$cm, and thus the resistance of the emitter becomes much lower than that of an n⁺ a-Si:H emitter having a resistivity of 100 $\Omega$cm. Furthermore, since the microcrystalline material is not a crystal, the problem of a lattice mismatch with Si, which occurs between $\beta$-SiC (crystal) and Si, does not occur.

After the base region is formed by doping the silicon substrate (i.e., the collector) with impurities, the above-mentioned microcrystalline material is formed on the base region by a plasma CVD process, to form a base-emitter heterojunction between the silicon substrate and the microcrystalline material.

Where the microcrystalline material is $\mu$c-Si:H, the plasma CVD process is preferably carried out under the following conditions:

gases: silane , H₂ , and doping gas
gas ratio: $1/200 <$ silane/H₂ $< 1/5$
growth temperature: 100 to 550°C
pressure: 0.01 to 1 Torr
power: 0.03 to 1 W/cm².

PH₃ gas is used as the doping gas when an n-type emitter of microcrystalline material is required, or B₂H₆ gas is used when a p-type emitter is desired. Note, Si₂H₆ , Si₃H₈ or the like, can be used as well as SiH₄.

If the ratio (SiH₄/H₂) of SiH₄ to H₂ of the above gases is 1/200 or less, the growth rate of $\mu$c-Si:H is very low, but if this ratio is 1/5 or more, the resistivity is increased. If the growth temperature is 550°C or more, a greater polycrystallization occurs and the bandgap of the $\mu$c-Si:H is decreased, but if this temperature is 100°C or less, the resistivity is increased. If the internal pressure in the plasma CVD apparatus is 0.01 Torr or less, defects occur on the surface of the base region, but, if this pressure is 1 Torr or more, tho resistivity is increased. Furthermore, if the electric power is 0.03 W/cm² or less, the resistivity is increased, but if this power is 1 W/cm² or more, defects appear on the surface of the base region. The above-mentioned increase in the resistance is caused by the augmentation of the amorphous substance in the mixed crystal $\mu$c-Si:H.

Where the microcrystalline material is $\mu$c-Si:H:F, the plasma CVD process is preferably carried out under the following conditions:

gases: fluorosilane , $H_2$ and doping gas
gas ratio: 1/400 < fluorosilane/$H_2$ < 1/5
growth temperature: 120 to 500°C
pressure: 0.02 to 1 Torr
power: 0.05 to 0.8 W/cm².
Note, $Si_2F_6$ , $SiHF_3$ , $SiH_2F_2$ or the like, can be used instead of $SiF_4$.

If the ratio ($SiF_4$/$H_2$) of silicon fluoride gas to hydrogen gas is 1/5 or more, the fluorine causes etching to occur, and thus the $\mu$c-Si:H:F does not grow. But, if this ratio is 1/400 or less, the growth rate is very low. If the growth temperature is 120°C or less, the amorphous content of $\mu$c-Si:H:F is increased and therefore the resistivity becomes high, but if this temperature is 550°C or more, a greater polycrystallization occurs, and thus the bandgap becomes small. If the pressure in the plasma CVD apparatus is 0.02 Torr or less, defects occur on the surface of the base region, but if this pressure is 1 Torr or more, the resistivity is increased. Furthermore, if the electric power is 0.05 W/cm² or less, the resistivity is increased, and conversely, if this power is 0.8 W/cm² or more, defects appear on the surface of the base region.

When the plasma CVD process is used for the microcrystalline material, the growth temperature is, as described above, 100 to 500°C, which is much lower than the 1,000°C needed for $\beta$-SiC, and thus expansion of the already formed base region does not occur.

An emitter electrode is formed on the emitter of the microcrystalline material to form a wiring, but at this time, if Al or an alloy (Al-Si, Al-Si-Cu or the like) thereof, which is widely used, is selected as the electrode, a reaction between Al and the microcrystalline material occurs even at a low temperature (e.g., 150°C). To prevent this reaction, a barrier layer having a thickness of 20 nm or more should be formed between the emitter of the microcrystalline material and the Al emitter electrode. This emitter electrode may be made of a metal other than Al, a nitride, a carbide or a silicide of the metal (e.g., Cr, Ni, Ti, Mo, W, Ta, WSi, MoSi, TiN, TiC, ZrN, TaSi or the like), and in this case, a barrier layer is not required. The barrier layer for the Al emitter electrode may be made of the above-mentioned emitter electrode material.

For a better understanding of the invention and to show how the same can be carried into effect reference will now be made by way of example only to the accompanying drawings, wherein;

Fig. 1 is a schematic sectional view of an HBT according to the present invention;

Fig. 2 is an energy-band diagram of the HBT of Fig. 1;

Figs. 3A to 3G are schematic sectional views of the HBT of Fig. 1 in various stages of production in accordance with the method of the present invention;

Fig. 4 is a diagram showing $I_C$-$V_{CE}$ character istics of the HBT;

Fig. 5 is a diagram showing the relationship between barrier layer thickness and current gain after annealing;

Fig. 6 is a diagram showing the relationship between the resistivity of the $\mu$c-Si:H layer and the temperature;

Fig. 7 is a diagram showing the relationship between the contact resistance of the $\mu$c-Si:H with Al and the temperature; and

Fig. 8 is a diagram showing the relationship between a maximum current gain of the HBT and the temperature.

Referring to Fig. 1, a heterojunction bipolar transistor (HBT, as an npn-type transistor) according to the present invention, comprises an n-silicon collector substrate 1, a $p^+$-doped base region 2, an $n^+$-microcrystalline material layer emitter (e.g., $n^+$-$\mu$c-Si:H layer) 3, a collector electrode 4, a base electrode 5, and an emitter electrode 6. Figure 1 shows a barrier layer 7 required only when the emitter electrode 6 is made of Al or Al alloy; i.e., if the emitter electrode 6 is made of a conductive material (e.g., Cr) other than Al, the barrier layer is not necessary.

An npn-type HBT having an $n^+$-$\mu$c-Si:H emitter 3 and Al emitter electrode 6 is produced, for example, in the following manner.

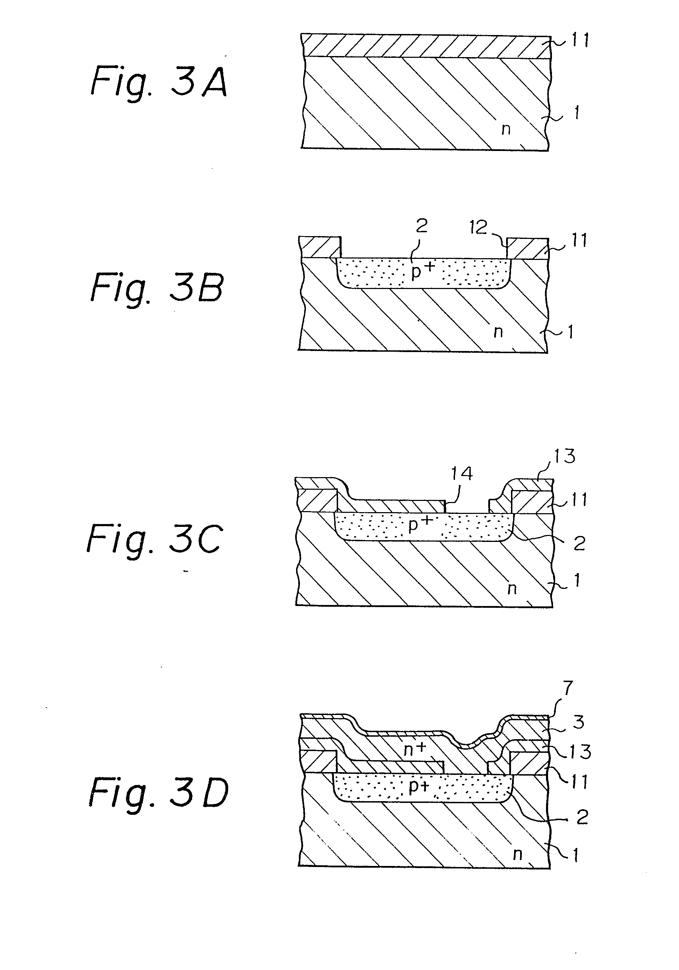

As shown in Fig. 3A, an $SiO_2$ layer 11 having a thickness of, e.g., 300 nm, and acting as an insulating layer is formed on the n-silicon substrate 1 by a selective thermal oxidation process.

As shown in Fig. 3B, the $SiO_2$ layer 11 is selectively etched by a lithography process to form a window 12, in which a portion of the silicon substrate 1 is exposed. Acceptor impurities (e.g., B) are introduced into the exposed portion of the silicon substrate 1 through the window 12 to form the $p^+$-base region 2 by an ion-implantation process (at a boron dosage of $5 \times 10^{12}$ to $1 \times 10^{15}$ cm$^{-2}$ and an energy level of 35 keV). After the ion-implantation process is completed, annealing is carried out at 900°C. A heat diffusion process may be employed, instead of the ion-implantation process, to form the $p^+$-region 2.

Next, as shown in Fig. 3c, an $SiO_2$ layer 13 having a thickness of, e.g., 200 nm, and acting as an insulating layer is formed over the whole surface by a CVD process. The $SiO_2$ layer 13 is selectively etched by a lithography process to form a window 14 for the emitter, in which a portion of the base region 2 is exposed.

As a pretreatment for the growth (deposition) of $\mu$c-Si:H, the exposed surface of the silicon substrate 1 within the window 14 is slightly etched with a solution containing an acid. Subsequently, as shown in Fig. 3D, the $n^+$-$\mu$c-Si:H layer 3 having a thickness of, e.g., 400 nm, is formed over all of the exposed silicon surface within the window 14 and the $SiO_2$ layer 13 by a plasma CVD apparatus under the following conditions:

gases: $SiH_4$, $H_2$ and $PH_3$
gas ratio: $PH_3:SiH_4:H_2 = 1:100:500$
growth temperature: 250°C
pressure in the apparatus: 0.1 Torr
RF power: 0.5 W/cm².

The formed μc-Si:H layer 3 is n⁺-type, due to the doping of phosphorus, and has a resistivity of 0.1 Ωcm, a conduction band (δ) of 0.05 eV, and an energy gap (Eg) of 1.7 eV (Fig. 2). The energy gap is larger than that of a single crystalline silicon of 1.1 eV, and therefore, the layer 3 constitutes a wide-gap emitter. A barrier layer having a thickness of, e.g., 30 nm, of a metal (e.g., Cr) is formed on the μc-Si:H layer 3 by a sputtering process.

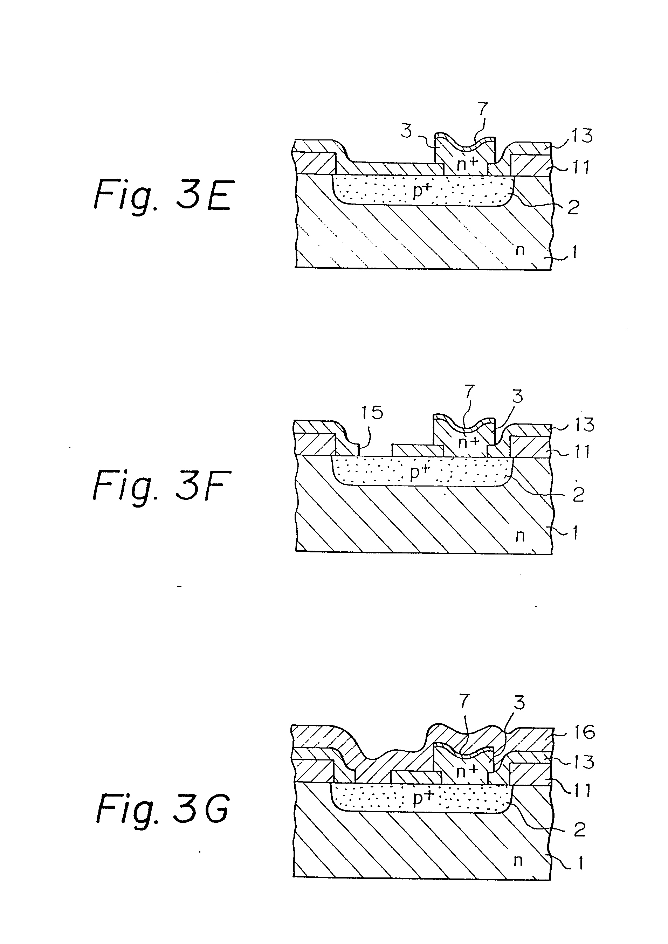

As shown in Fig. 3E, the barrier layer 7 and the μc-Si:H layer 3 are selectively etched by a lithography process to form an emitter having a heterojunction with the silicon substrate 1 at the base region 2.

As shown in Fig. 3F, the $SiO_2$ layer 13 is selectively etched by a lithography process to form a window 15, in which a portion of the base region 2 is exposed.

Next, as shown in Fig. 3G, an Al layer 16 having a thickness of, e.g., 1 μm, is formed over the whole surface by a vacuum evaporation process. The Al material may be replaced by metals, or nitride, carbide or silicide of the metals (e.g., Cr, Ni, Ti, Mo, W, Ta, WSi, MoSi, TiN, TiC, ZrN, TaSi or the like), and in this case, the formation of the barrier layer is not required.

Thereafter, as shown in Fig. 1, the Al layer 16 is selectively etched by a lithography process to form the base electrode 5, coming into contact with the base region 2 and the emitter electrode 6 on the barrier layer 7, which electrodes 5 and 6 form wirings, i.e., interconnections. Then the collector electrode 4 is formed on the back surface of the silicon substrate 1, and thus the desired HBT is produced.

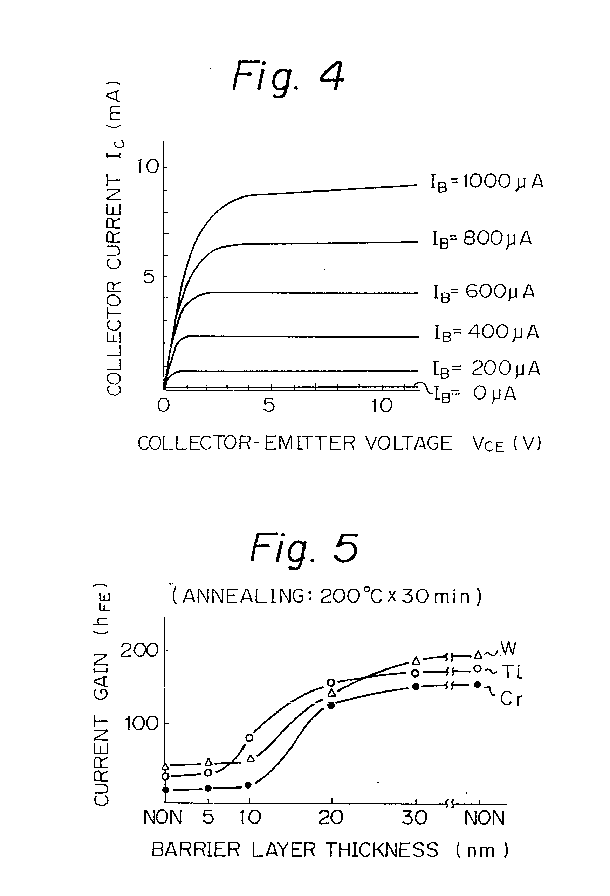

The produced HBT has an energy band diagram as shown in Fig. 2 at the emitter-base-collector. As apparent from Fig. 2, the energy gap of the emitter is larger than that of the base, so that electrons (current) flow from the emitter to the collector, but holes do not extend from the base to the emitter. When the base dose is $5 \times 10^{12}$ cm⁻² the current gain (current amplification factor, $h_{FE}$) of the HBT is 900, which is much greater than the $h_{FE}$ of a conventional silicon bipolar transistor, i.e., about 100. Even when the base dose is $1 \times 10^{15}$ cm², the $I_C$-$V_{CE}$ characteristics of the HBT become as shown in Fig. 4, and an $h_{FE}$ of 12 is obtained. Conversely, the conventional silicon bipolar transistor does not show a current gain in the case of such a large base dose.

Where the emitter electrode of Al (or an Al alloy) is formed on the emitter of a microcrystalline material such as μc-Si:H, a reaction therebetween occurs even at about 150°C, with a resulting degradation of the HBT characteristics (decline of the $h_{FE}$ thereof). To examine the deterioration of the HBT characteristics after annealing at 200°C for 30 minutes, HBT samples having the emitter electrodes and barrier layers as in Table 1 were prepared. In these samples, the base electrodes were made of Al.

Table 1

| Sample | Emitter Electrode | Barrier Layer | Thickness (nm) |
|---|---|---|---|
| 1 | Al | none | |
| 2 – 5 | Al | Cr | 5, 10, 20, 30 |
| 6 – 9 | Al | Ti | 5, 10, 20, 30 |
| 10 – 13 | Al | W | 5, 10, 20, 30 |
| 14 | Cr | none | |
| 15 | Ti | none | |
| 16 | W | none | |

The results are shown in Fig. 5. As apparent from Fig. 5, where the thickness of the barrier layer is 20 nm or more, the reaction between Al and μc-Si:H can be prevented regardless of the material of the barrier layer.

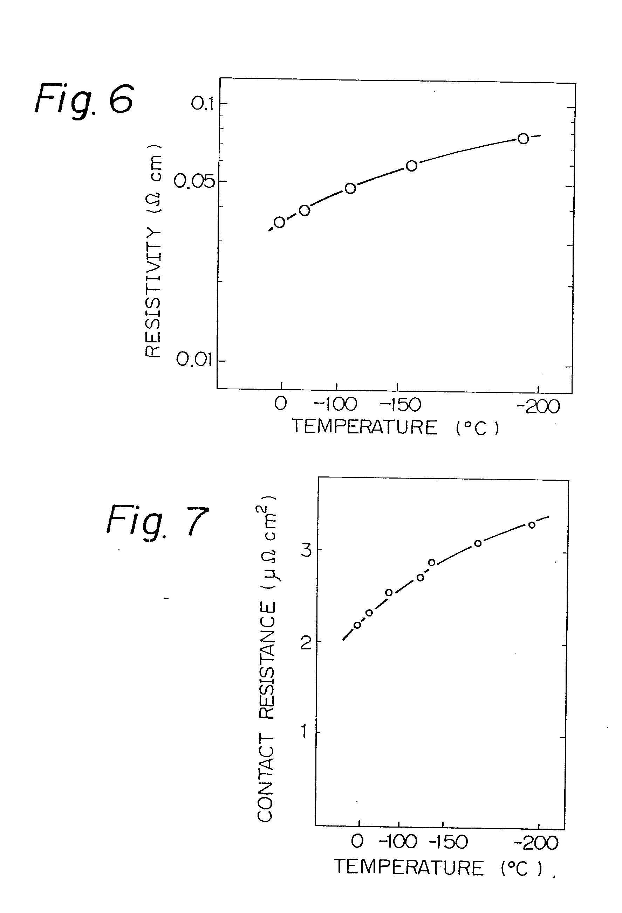

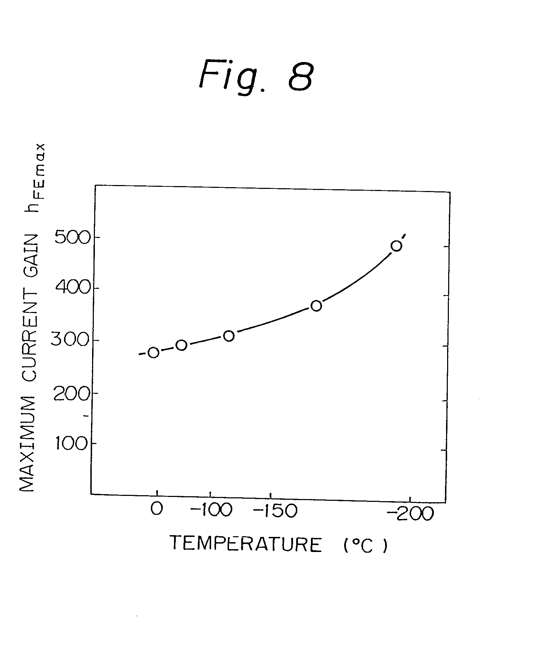

An HBT having a base sheet resistance of 5.0 kΩ/was produced in the manner shown in Figs. 1 and 3A to 3G. The resistivity of the μc-Si:H layer, the contact resistance of the μc-Si:H layer with the Al emitter electrode, and the maximum common emitter current gain of the HBT were measured under a low temperature of from 27°C to -196°C (liquid nitrogen temperature). The results are shown in Figs. 6, 7, and 8, respectively. As seen in Figs. 6 and 7, the resistivity and the contact resistance was increased with a lowering of the temperature. But, as seen in Fig. 8, the current gain $h_{EF}$ of the HBT was increased from 280 to 500 as the temperature was reduced from 27°C to -196°C. This HBT can operate satisfactorily even at -196°C, whereas most conventional silicon bipolar transistors designed for room temperature operation suffer a serious degradation of the current gain at -196°C due to a narrowing of the bandgap in the emitter.

According to the present invention, an HBT having a widegap emitter of a microcrystalline material is obtained, this emitter having a low resistance and forming a good heterojunction with a base region in a silicon substrate, with the result that a high current gain is obtained. The base resistance of the HBT can be reduced while maintaining high current gain, and thus the HBT can operate at a higher speed than can a conventional silicon bipolar transistor.

## Claims

1. A heterojunction bipolar transistor comprising a silicon substrate collector, an impurity-doped base region in said substrate, an emitter of a microcrystalline material selected from
μc-Si:H, μc-SiN:H, μc-SiGe:H, μc-Si:H:F, μc-SiN:H:F, andμc-SiGe:H:F formed on said base region, and an emitter electrode formed on said emitter.

2. A heterojunction bipolar transistor according to claim 1, wherein said emitter electrode is composed of an Al wiring and a barrier layer disposed between said Al wiring and said emitter of said microcrystalline material.

3. A heterojunction bipolar transistor according to claim 2, wherein said barrier layer is made of a material selected from metals other than Al, and nitrides, carbides and silicides of those metals.

4. A heterojunction bipolar transistor according to claim 1, wherein said emitter electrode is made of a material selected from metals other than Al, and nitrides, carbides and silicides of those metals.

5. A method of producing a heterojunction bipolar transistor comprising the steps of:
introducing impurities into a silicon substrate to form a base region;
forming an emitter of a microcrystalline material selected from μc-Si:H, μc-SiN:H, μc-SiGe:H, μc-Si:H:F, μc-SiN:H:F and μc-SiGe:H:F on said base region by a plasma CVD process; and
forming an emitter electrode on said emitter.

6. A method according to claim 5, wherein said microcrystalline material of μc-Si:H is formed by a plasma CVD process under the following conditions:
gases: Silane . $H_2$ and doping gas
gas ratio: $1/200 <$ Silane/$H_2 < 1/5$
growth temperature: 100 to 550°
pressure: 0.01 to 1 Torr
power: 0.03 to 1 W/cm$^2$.

7. A method according to claim 5, wherein said microcrystalline material of c-Si:H:F is formed by a plasma CVD process under the following conditions:
gases: fluorosilane , $H_2$ and doping gas
gas ratio: $1/400 <$ fluorosilane $< H_2 < 1/5$
growth temperature: 120 to 500°C
pressure: 0.02 to 1 Torr
power: 0.05 to 0.8 W/cm$_2$.

8. A method according to claim 6, wherein the silane is $SiH_4$, $Si_2H_6$ or $Si_3H_8$.

9. A method according to claim 7, wherein the fluorosilane is $SiF_4$, $Si_2F_6$, $SiHF_3$ or $SiH_2F_2$.

10. A method according to any one of claims 6 to 9 wherein doping is carried out with $PH_3$ when an n-type emitter of microcrystalline material is required or with $B_2H_6$ when a p-type emitter is required.

# Fig. 1

# Fig. 2

ELECTRONS

$1.1 eV$

$\delta = 0.05 eV$

$1.7 eV$

HOLES

$\Delta E_{VC} = 0.4 eV$

| EMITTER | BASE | COLLECTOR |
|---|---|---|
| $(n^+ \mu c - Si:H)$ | $(p^+ - Si)$ | $(n - Si)$ |

0292278

Fig. 3A

Fig. 3B

Fig. 3C

Fig. 3D

0292278

Fig. 3E

Fig. 3F

Fig. 3G

## Fig. 4

COLLECTOR CURRENT $I_C$ (mA)

10

$I_B = 1000 \mu A$

$I_B = 800 \mu A$

5

$I_B = 600 \mu A$

$I_B = 400 \mu A$

$I_B = 200 \mu A$

$I_B = 0 \mu A$

0     5     10

COLLECTOR-EMITTER VOLTAGE $V_{CE}$ (V)

## Fig. 5

( ANNEALING: 200°C × 30 min )

CURRENT GAIN ($h_{FE}$)

200            △~W

                  ○~Ti

                  ●~Cr

100

NON   5   10     20     30    NON

BARRIER LAYER THICKNESS ( nm )

0292278

**Fig. 6**

**Fig. 7**

0292278

Fig. 8

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | EP-A-0 178 004 (IMEC INTER UNIVERSITAIR MICRO-ELECTRONICA CENTRUM) * Whole document * | 1,5,6,8 | H 01 L 29/04 H 01 L 29/08 |
| A | US-A-4 254 429 (YAMAZAKI) * Abstract; figure 1; column 2, line 67 - column 4, line 51; column 6, lines 4-32 * | 1 | |
| A | EP-A-0 069 580 (TOA NENRYO KOGYO K.K.) * Abstract; page 7, line 18 - page 9, line 6; table 1; page 18, line 15 - page 20, line 5; table 2 * | 6,7,8 | |
| A | IEEE ELECTRON DEVICE LETTERS, vol. EDL-6, no. 6, June 1985, pages 288-290, IEEE, New York, US; M.B. ROWLANDSON et al.: "A true polysilicon emitter transistor" * Figure 1; page 288, paragraph II * | 1,5 | |
| A | EP-A-0 156 647 (HITACHI) * Figure 1; page 1, lines 8-18 * | 2-4 | **TECHNICAL FIELDS SEARCHED (Int. Cl.4)** H 01 L 29 |

The present search report has been drawn up for all claims

| Place of search | Date of completion of the search | Examiner |
|---|---|---|
| THE HAGUE | 11-08-1988 | MIMOUN B.J. |

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | EP-A-0 178 004 (IMEC INTER UNIVERSITAIR MICRO-ELECTRONICA CENTRUM) * Whole document * | 1,5,6,8 | H 01 L 29/04 H 01 L 29/08 |
| A | US-A-4 254 429 (YAMAZAKI) * Abstract; figure 1; column 2, line 67 - column 4, line 51; column 6, lines 4-32 * | 1 | |
| A | EP-A-0 069 580 (TOA NENRYO KOGYO K.K.) * Abstract; page 7, line 18 - page 9, line 6; table 1; page 18, line 15 - page 20, line 5; table 2 * | 6,7,8 | |
| A | IEEE ELECTRON DEVICE LETTERS, vol. EDL-6, no. 6, June 1985, pages 288-290, IEEE, New York, US; M.B. ROWLANDSON et al.: "A true polysilicon emitter transistor" * Figure 1; page 288, paragraph II * | 1,5 | |
| A | EP-A-0 156 647 (HITACHI) * Figure 1; page 1, lines 8-18 * | 2-4 | TECHNICAL FIELDS SEARCHED (Int. Cl.4) H 01 L 29 |

The present search report has been drawn up for all claims

| Place of search | Date of completion of the search | Examiner |
|---|---|---|
| THE HAGUE | 11-08-1988 | MIMOUN B.J. |